# EUROPEAN PATENT SPECIFICATION

(11) **EP 0 534 372 B1**
(45) Date of publication and mention of the grant of the patent: **01.02.1995**
(21) Application number: 92116201.2
(22) Date of filing: 22.09.1992
(51) Int. Cl.: H05K 9/00

(54) **EMI filter and shield for printed circuit board**
Elektromagnetisches Filter und Abschirmung für eine Leiterplatte
Filtre d'interferences électromagnétique et blindage pour une plaque de circuit imprimé

(30) Priority: 23.09.1991 US 764434
(43) Date of publication of application: 31.03.1993
(73) Proprietor: OTIS ELEVATOR COMPANY, Farmington, CT 06032 (US)
(72) Inventor: Schröder-Brumloop, Helmut L., W-1000 Berlin 28 (DE)
(74) Representative: Klunker . Schmitt-Nilson . Hirsch

(56) References cited:
- US-A- 4 214 360
- US-A- 4 658 334
- US-A- 4 739 453

## Description

### TECHNICAL FIELD

The present invention relates to an assembly for protecting printed circuit boards (PCBs) from electromagnetic interference (EMI).

### BACKGROUND OF THE INVENTION

Electronic circuits with fast switching devices (logic and/or power devices) produce interference in a wide spectral range. Laws and codes set limits to the amount of noise transmitted through the air and through wires to protect other equipment against disturbances and malfunction. At the same time, interferences in the environment must not influence the function of a circuit. For both reasons, a shield (for example, a metallic box) enclosing a circuit is a sufficient solution. Guarding and filtering wires is expensive. Each wire receives high frequency noise in the disturbed environment like an antenna, transfers it through the outlet, and radiates it at the other side of the shield. The damping of the received signal must be done at the point of the feed-through of the wire at the shield.

There are many devices for protecting printed circuit boards (PCBs) from EMI. An enclosure for protecting from RF interference is presented in U.S. Patent No. 4,658,334, "RF Signal Shielding and Enclosure of Electronic Systems". The reference discloses an enclosure for electronic systems providing substantially total RF isolation of separate segments from one another except for the transmission of desired signals between different segments, even though the various segments are fabricated on a common circuit board. A special multi-layer circuit board configuration makes this isolation feasible. Conductors which must connect the RF isolated circuit zone to the region external thereto are disposed in signal layers of the multilayer PCB, which layers are adjacent to the ground layer of the circuit board and are preferably provided with driver and receiver buffer circuits which prevent the transmission of stray signals along with or as part of the signal intended to be transmitted.

One way to connect the PCB to wires outside the PCB is the use of feed-through capacitors. This successfully keeps EMI within the shield. However, this use of a feed-through capacitor is an expensive solution.

### DISCLOSURE OF THE INVENTION

According to the present invention as claimed, an EMI shielding box is provided for a printed circuit board (PCB). The box includes a separation wall separating electromagnetic interference radiating circuit components within the box from the PCB input/output cables outside the box. A slit in the separation wall is large enough to pass a fully assembled PCB through it. The slit is closed with a metallic plate.

It is the object of the present invention to shield conductors provided to a PCB from electromagnetic interference (EMI) emitted from circuit elements on the circuit board and to shield the circuit elements on the circuit board from EMI emitted from conductors provided to that circuit board.

These and other objects, features and advantages of the present invention will become more apparent in light of the following detailed description of a best mode embodiment thereof, as illustrated in the accompanying drawing.

### BRIEF DESCRIPTION OF THE DRAWINGS

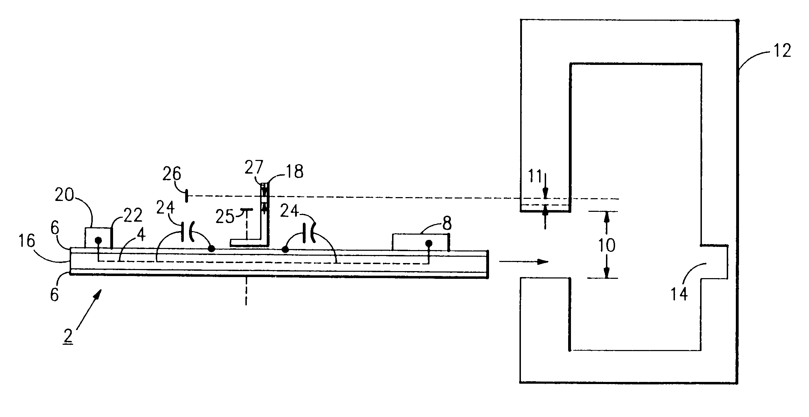

Fig. 1 is a cut-away side view of the invention.

### DETAILED DESCRIPTION OF THE INVENTION

With reference to Fig. 1, there is shown a multilayer printed circuit board (PCB) 2, including printed circuit trace 4 (shown as a dotted line) and ground trace 6. Circuit block 8, comprising a plurality of various fast switching electronic elements including transistors, is mounted on the top surface of the PCB 2 for sliding through a slit 10 of a metallic box 12. The metallic box 12 has a hole 11 for receiving a screw 26. The PCB 2 is capable of sliding into a groove 14.

The PCB 2 is shown in cross-section and includes a dielectric substrate 16 having the ground trace 6 on the top and bottom of the PCB 2 and a circuit trace 4 sandwiched between the two ground traces 6. Thus, the arrangement of ground trace 6, circuit trace 4, and ground trace 6 functions as a coaxial cable with the ground trace 6 acting as an outer conductor. The grounding trace 6 contacts the metallic box 12, but the circuit trace 4 does not contact the metallic box 12.

A metallic plate 18 is mounted on the PCB 2 such that when the PCB 2 is slid in the direction of the groove 14, the circuit block 8 passes through the slit 10 and enters the metallic box 12 but the metallic plate, and therefore a signal port 20, does not. This keeps EMI emitted from electronic components inside the metallic box 12 and EMI emitted from outside the box, for example from a signal line 22 or signal port 20 outside of the box. Thus, components inside the metallic box 12 may operate free of EMI created outside of the box and electronic components outside of the metallic box 12 may operate free of EMI created inside the metallic box 12. A conductive screw 26 fastens the metallic plate 18 to the metallic box 12 via a hole 27 in the metallic plate and the hole 11 in the metallic box 12. The metallic plate 18 and metallic box 12 are made of stainless steel coated with zinc or nickel. The metallic plate 18 is fastened to the PCB 2 by means of a screw 25 and a through hole (not shown) in the PCB 2.

A buffer capacitor 24 is placed on either side of the metallic plate 18 for filtering high frequency noise out of a signal on the circuit trace 4 passing between the circuit block 8 and signal port 20. The buffer capacitors 24 are connected between the circuit trace 4 and ground trace 6 via through-holes (not shown). The circuit block 8 is connected to the signal port 20 via circuit trace 4. The circuit block 8 and signal port 20 connect to the circuit trace 4 via through holes (not shown).

The sandwiching process may be performed by taking two dielectric substrates printing the circuit trace 4 on one dielectric and pressing the two dielectric substrates together while the circuit trace 4 is between them and holding them there with epoxy. Then, the outer surfaces of the dielectric substrates may be coated with the ground trace 6.

## Claims

1. An EMI shielding enclosure for a circuit on a printed circuit board (2), comprising:
a printed circuit board (2) having first and second ends, said first end for mounting circuit elements (8) and a circuit trace (4) and a ground trace (6), each common to both ends;
a metallic plate (8), mounted upon said printed circuit board (2) and separating said first end from said second end; and
a metallic box (12) having a slit (10) large enough that said first end of said printed circuit (2) board may pass through said slit (10) but small enough that said metallic plate (18) may not pass through said slit (10) and close the slit.

2. The enclosure of claim 1, characterized in that it further comprises at least two bypass capacitors (24), one mounted on either side of said metallic plate (18), connecting said ground trace (6) to said circuit trace (4).

## Patentansprüche

1. EMI-Abschirmungsgehäuse für eine Schaltung auf einer Schaltungsplatte (2), umfassend eine Schaltungsplatte (2) mit einem ersten und einem zweiten Ende, von denen das erste Ende zur Lagerung von Schaltungselementen (8) dient, und mit einer Stromkreisbahn (4) und einer Erdungsbahn (6) jeweils gemeinsam für beide Enden;
eine metallische Platte (8), die auf der gedruckten Schaltungsplatte (2) gelagert ist und das erste Ende von dem zweiten Ende trennt; und
einen metallischen Kasten (12) mit einem Schlitz (10), der groß genug ist, damit das erste Ende der gedruckten Schaltungsplatte (2) durch den Schlitz (10) hindurch gelangen kann, jedoch klein genug ist, damit die Metallplatte (28) nicht durch den Schlitz (10) gelangen kann, und den Schlitz verschließt.

2. Gehäuse nach Anspruch 1, dadurch gekennzeichnet, daß es außerdem mindestens zwei Nebenschluß-Kondensatoren (24) aufweist, von denen jeweils einer auf einer Seite der Metallplatte (10) gelagert ist und die Erdungsbahn (6) mit der Stromkreisbahn (4) verbindet.

## Revendications

1. Enceinte de blindage contre les parasites électromagnétiques pour un circuit porté par un circuit imprimé (2), comprenant :
un circuit imprimé (2) ayant des première et deuxième extrémités, ladite première extrémité étant prévue pour monter des éléments de circuit (8) ainsi qu'un tracé de circuit (4) et qu'un tracé de masse (6), dont chacun est commun aux deux extrémités ;
une plaque métallique (18) montée sur ledit circuit imprimé (2) et qui sépare ladite première extrémité de ladite deuxième extrémité ; et
une boîte métallique (12) ayant une fente (10) suffisamment grande pour que ladite première extrémité dudit circuit imprimé (2) puisse passer à travers ladite fente (10) mais suffisamment petite pour que ladite plaque métallique (18) ne puisse pas passer à travers ladite fente (10) et pour qu'elle puisse fermer cette fente.

2. Enceinte selon la revendication 1, caractérisée en ce qu'elle comprend en outre au moins deux condensateurs de dérivation (24) montés chacun d'un côté de ladite plaque métallique (18), et qui connectent ledit tracé de masse (6) audit tracé de circuit (4).
